# EUROPEAN PATENT APPLICATION

(11) **EP 3 742 227 A1**
(43) Date of publication of application: **25.11.2020**
(21) Application number: 19176260.8
(22) Date of filing: 23.05.2019
(51) Int. Cl.: G03F 7/00, H01L 21/31, H01L 31/18, H01L 21/288, C25D 5/02, H01L 51/44, H01L 31/0224, H01L 31/0747

(54) **METHOD OF MANUFACTURING A PHOTOVOLTAIC CELL**

(71) Applicant: CSEM Centre Suisse d'Electronique et de Microtechnique SA, 2002 Neuchâtel (CH)
(72) Inventor: ANDREATTA, Gaëlle, 2000 Neuchâtel (CH); ALLEBÉ, Christophe, 2000 Neuchâtel (CH); LACHOWICZ, Agata, 2000 Neuchâtel (CH); BLONDIAUX, Nicolas, 2206 Les Geneveys-sur-Coffrane (CH); FAES, Antonin, 1462 Yvonand (CH)
(74) Representative: e-Patent SA

(57) **Abstract**

Method of manufacturing a photovoltaic cell (1), comprising the steps of:
- providing a photovoltaic conversion device (3);
- providing a transparent conductive oxide layer (5) upon at least a first face of said photovoltaic conversion device (3);
- forming a self-assembled monolayer (9) on said transparent conductive oxide layer (5), said self-assembled monolayer (9) being based on molecules terminated by at least one group F which is chosen from: a phosphonic acid group, a P(O)O₂⁻M⁺ group, a OPO₃H₂ group, or an OP(O)O2⁻M⁺ group, wherein M⁺ is a metal cation;
- patterning said self-assembled monolayer (9) so as to define at least one plateable zone (9a) in which said transparent conductive oxide layer (5) is exposed;
- plating a metal (11) onto said at least one plateable zone (9a).

## Description

### Technical Field

The present invention relates to the technical field of photovoltaic devices. More particularly, it relates to a method of manufacturing such a device, as well as to an intermediate product manufactured by this method.

### State of the art

During the manufacture of photovoltaic devices such as silicon heterojunction cells or copper indium gallium selenide (CIGS) cells, it is typically required to form electrical contacts, electrical tracks and similar metallic features on top of a transparent conductive oxide (TCO) layer, in order to provide conduction pathways for photoelectrically-generated electrons. Such TCO layers typically are formed of doped or undoped conductive oxides such as indium zinc oxide (IZO), indium tin oxide (ITO), aluminium zinc oxide (AZO) and so on.

One conventional approach involves deposition of a patterned photoresist layer, the gaps in which define the zones in which the metallic features will be formed. The photoresist layer is first deposited over the whole area concerned and is then selectively exposed to UV light through a mask, or by means of a laser. Depending on whether the resist is of positive or negative type, either the unexposed or the exposed zones are removed by solvent.

Subsequently, the metallic features are deposited by electroplating or electroless (autocatalytic) plating, and the resist is removed, leaving the metallic features in the desired zones. An example of such a lithographic process is disclosed in US2014/349441.

This technique is time-consuming, and requires a significant amount of materials, solvents etc. As a result, alternatives have been proposed.

For instance, EP2105969, discloses the use of patterned self-assembled monolayers deposited together with a metal catalyst solution to enhance or initiate localized electroplating or electroless plating. This, however, exposes the underlying material to the plating solution, and risks deposition of metal in undesired locations. Other examples of uses of patterned SAM layers in a similar context are disclosed in US2010/124619, WO15156912 and WO17095485.

US9577140 discloses a method for applying copper tracks to a photovoltaic device, involving treating the TCO layer to become hydrophilic prior to deposition, sputtering a copper seed layer, and then electroplating copper. This method is also somewhat complicated, requiring vacuum chamber deposition to sputter the seed layer.

Other technologies such as direct screen printing of silver paste, printing of conductive inks and similar are also known in the art.

An aim of the present invention is thus to at least partially overcome the above-mentioned disadvantages of the prior art.

### Disclosure of the invention

More specifically, the invention relates to a method of manufacturing a photovoltaic cell, as defined in claim 1.

This method comprises the steps of:
- providing a photovoltaic conversion device, which may comprise at least one PN, NP, NIP, PIN junction arranged to generate electrical energy from impinging light energy as is generally known. This photovoltaic junction may be based on at least one of thin-film silicon (amorphous, microcrystalline, or even micromorph in the case of a dual junction cell), crystalline (i.e. monocrystalline) silicon, germanium, Perovskite, quantum dot cells, copper indium gallium selenide, cadmium telluride, dye sensitised cells, plasmonic cells, or any other convenient type. The PV device may be based on single layers of cells, multijunction cells, hybrid cells, etc. The PV conversion device 3 may be patterned as required, and may be front-side contacted, back-side contacted, or bifacially-contacted.
- providing a transparent conductive oxide (TCO) layer upon at least a first face of said photovoltaic conversion device, this TCO typically being indium tin oxide, indium zinc oxide, aluminium zinc oxide or similar. This first face may be the light incident side of the device, or may be the back side thereof. In the case of bifacial cells, this TCO layer is provided on both, opposite faces thereof.
- forming a self-assembled monolayer (SAM) on said transparent conductive oxide layer, said self-assembled monolayer being based on (i.e. comprising and/or consisting of) molecules terminated by at least one functional group F which is chosen from: a phosphonic acid group, a P(O)O₂⁻M⁺ group, a OPO₃H₂ group, or an OP(O)O₂⁻M⁺ group, wherein M⁺ is a metal cation. In the case in which multiple functional groups F are provided, these may be the same or different. This SAM can e.g. be formed by dip coating, spray coating, bar coating, spin coating, slot-die coating or similar, using a solution of said molecules in a suitable solvent such as ethanol or isopropanol. If necessary, the SAM can be cured, e.g. in a vacuum oven.
- patterning said self-assembled monolayer so as to define at least one plateable zone in which said transparent conductive oxide layer is exposed, i.e. by selective removal of predetermined portions of the SAM to expose the underlying TCO layer, thereby forming a plating mask. This can e.g. be carried out by selective laser ablation, reactive ion etching through a suitable mask (e.g. made a sheet of silicon, metal, or an appropriate polymer), selective application of acids, UV-Ozone, corona treatment, mechanical removal or similar, so as to selectively remove portions of the SAM layer. Such a SAM-based plating mask in which the presence of the SAM defines unplateable zones is clearly the exact opposite of the prior art concept of using a SAM as a plating enhancer / initiator upon which the plating is carried out.
- plating a metal onto said plateable zone or zones, particularly by means of electroplating or electroless plating, with or without use of a seed layer, which, if used, is deposited before the step of plating. The metal in question is typically copper or nickel, but silver and others such as tin, nickel, nickel phosphor, cobalt, titanium, tantalum, tungsten, molybdenum, alloys of the foregoing and so on are also possible.

Since very small amounts of SAM molecules are required compared to normal photoresists, and due to the fact that the method can be carried out with simple equipment and common solvents, the method is very economic to carry out. Furthermore, it is not always necessary to remove the SAM layer after metal plating since it is extremely thin and is transparent, which removes process steps and the corresponding use of solvents.

In one variant, said SAM molecules have at least one tail moiety comprising at least one of:
- a straight alkyl chain comprising at least two carbon atoms;
- a straight alkyl chain comprising at least two carbon atoms in which at least one hydrogen is substituted by a halogen;
- a branched alkyl chain comprising at least two carbon atoms;
- a straight perfluorinated alkyl chain comprising preferably from 1 to 100 atoms of carbon;
- a branched perfluorinated alkyl chain comprising preferably from 1 to 100 atoms of carbon;
- one or more aromatic rings;
- (CF(CF₃)CF₂O)_{q}(CF₂)ₜCF₃ with q between 0 and 100, and t between 2 and 100;
- (CF₂CF(CF₃)O)_{q}(CF₂)ₜCF₃ with q between 0 and 100, and t between 2 and 100;
- (CF₂CF₂CF₂O)_{q}(CF₂)ₜCF₃ with q between 0 and 100, and t between 2 and 100;
- (CF₂CF₂O)_{q}(CF₂)ₜCF₃ with q between 0 and 100, and t between 2 and 100.

In a variant, said SAM molecules are of the general formula F-R1-R'-R2, wherein :
- R1 is one of: an alkyl chain, an alkyl chain in which at least one hydrogen atom is substituted with a halogen, an aryl chain, an alkylaryl chain, an aralkyl chain, an aralkyl chain in which at least one hydrogen atom is substituted with a halogen, a branched alkyl chain, a branched aryl chain, a branched aralkyl chain, a branched alkylaryl chain, an oligothioether chain of formula (CH₂CH₂X)ₙ with X being an O or S atom and n being between 1 and 25.
- R' is one of : (CH₂)ₘ with m between 0 and 100, O, S, S-S, NH, O(CO), O(CS), NH(CO), NH(CS), NH(CO)NH, NH-CS-NH, NH(CO)O, NH(CS)O, S(CO), (CO)S, triazolium,
- R2 is one of: an alkyl chain, an alkyl chain wherein at least one atom of hydrogen is substituted by a halogen, an aryl chain, an alkylaryl, an aralkyl chain, an aralkyl chain wherein at least one atom of hydrogen is substituted by a halogen, a branched alkyl chain, a branched aryl chain, a branched aralkyl chain, a branched alkylaryl, an oligothioether of formula (CH₂CH₂X)ₚ with X being an O or S atom and p being between 1 and 25, a perfluoroalkyl chain comprising from 1 to 20 carbon atoms, (CF(CF₃)CF₂O)_{q}(CF₂)₂CF₃, (CF₂CF(CF₃)O)_{q}(CF₂)2CF₃, (CF₂CF₂CF₂O)_{q}(CF₂)₂CF₃, (CF₂CF₂O)_{q}(CF₂)CF₃, each with q between 0 and 100.

It should be noted that, in the foregoing, where chains are mentioned, these are typically between 1 and 50 carbons long, preferably between 2 and 50 carbons long, further preferably between 2 and 25 carbons long, further preferably from 8 to 20 carbons long and hence also include the smallest group of each category of molecule which comprises only one carbon atom.

Specific examples of such substances include:
- 12,12,13,13,14,14,15,15,15,15-Nonafluoropentadecylphosphonic acid,
- 12,12,13,13,14,14,15,15,16,16,17,17-Tridecafluoroseptadecylphosphonic acid,
- 12,12,13,13,14,14,15,15,16,16,17,17,18,18,19,19,19-Heptadecafluorononadecylphosphonic acid,
- 10-((3,3,4,4,5,5,6,6,7,7,8,8,9,9,10,10,10-Heptadecafluorodecyloxy)carbonyl)decylphosphonic acid,
- 5,7,7-Trimethyl-2-(4,4-dimethylpentan-2-yl)octylphosphonic acid,
- Diethyl-12-pentafluorophenoxydodecylphosphonate,
- octadecylphosphonic acid,
- decylphosphonic acid,
- dodecylphosphonic acid,
- octylphosphonic acid.

In another variant, said molecules are of the general formula 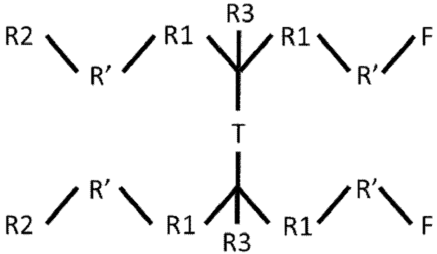 wherein:
- R1 is one of: an alkyl chain, an alkyl chain in which at least one hydrogen is substituted by a halogen, an aryl chain, an alkylaryl, an aralkyl chain, an aralkyl chain in which at least one hydrogen is substituted by a halogen, a branched alkyl chain, a branched aryl chain, a branched aralkyl chain, a branched alkylaryl, an oligothioether of formula (CH₂CH₂X)ₙ with X being an O or S atom and n being between 1 and 25.
- R' is one of: a bond, (CH₂)ₘ with m between 0 and 100, O, S, S-S, NH, O(CO), O(CS), NH(CO), NH(CS), NH(CO)NH, NH-CS-NH, NH(CO)O, NH(CS)O, S(CO), (CO)S, a triazolium bond,
- R2 is one of: alkyl chain, an alkyl chain in which at least one hydrogen is substituted by a halogen, an aryl chain, an alkylaryl, an aralkyl chain, an aralkyl chain in which at least one hydrogen is substituted by a halogen, a branched alkyl chain, a branched aryl chain, a branched aralkyl chain, a branched alkylaryl, an oligothioether of formula (CH₂CH₂X)ₚ with X being an O or S atom and p being between 1 and 25, a perfluoroalkyl chain comprising from 1 to 20 carbon atoms, (CF(CF₃)CF₂O)_{q}(CF₂)2CF₃, (CF₂CF(CF₃)O)_{q}(CF₂)₂CF₃, (CF₂CF₂CF₂O)_{q}(CF₂)₂CF₃, (CF₂CF₂O)_{q}(CF₂)CF₃ each with q between 0 and 100.
- T is one of: a bond, (CH₂)ᵣ with r between 0 and 100, O, S, S-S, NH, O(CO), O(CS), NH(CO), NH(CS), NH(CO)NH, NH-CS-NH, NH(CO)O, NH(CS)O, S(CO), (CO)S, a triazolium bond,
- R3 is one of: H, an alkyl group, an alkyl group in which at least one hydrogen is substituted by a halogen, an aryl group, a branched alkyl, a branched aryl chain, an aralkyl group, an oligothioether of formula (CH₂CH₂X)ₛ with X being an O or S atom and s being between 1 and 25.

It should be noted that, in the foregoing, where chains are mentioned, these are typically between 1 and 50 carbons long, preferably between 2 and 25 carbons long, further preferably from 8 to 20 carbons long, and hence also include the smallest group of each category of molecule which comprises only one carbon atom.

A specific example of such a substance is 10,11-Bis(2,2,3,3,4,4,5,5,6,6,7,7,8,8,9,9,9-Heptadecafluorononyl)icosane-1,20-diyldiphosphonic acid.

Advantageously, after said step of plating, said self-assembled monolayer is left in place and is not removed during subsequent processing. This is significantly simpler than lithographic processes, in which removal of the masking layer is obligatory.

Typically, said self-assembled monolayer has a thickness or 2 nm to 5 nm, preferably from 3 nm to 4 nm. This is sufficiently thin to ensure that the SAM layer is transparent and can be left in place if desired during further processing.

Advantageously, self-assembled monolayer is cured in a vacuum oven prior to said step of patterning.

In a variant, said self-assembled monolayer is formed by:
- a first application of said molecules, e.g. by spraying said molecules in solution;
- a first drying and curing;
- a second application of said molecules; and
- a subsequent drying and curing.

Advantageously, said patterning is carried out by at least one of:
- selective laser ablation;
- reactive ion etching through a mask;
- selective application of an acid.

The invention likewise relates to an intermediate product which will subsequently be assembled into a photovoltaic module, this intermediate product comprising:
- a photoelectric conversion device;
- a transparent conductive oxide layer provided upon said photoelectric conversion device;
- a patterned self-assembled monolayer provided upon said transparent conductive oxide layer and defining at least one plateable zone free of said self-assembled monolayer, said self-assembled monolayer being based on molecules terminated by at least one group F which is one of: a phosphonic acid group, a P(O)O₂⁻M⁺ group, an OPO₃H₂ group, or an OP(O)O₂⁻M⁺ group, wherein M⁺ is a metal cation such as Na⁺ or K⁺; and
- a metallic layer provided on said at least one plateable zone.

This intermediate product is the necessary result of the methods as described above. One or more of these can be incorporated into a PV module with the SAM layer left in situ or removed, interconnected as required.

Advantageously, the molecules constituting the self-assembled monolayer can comprise one or more tail moieties as described above, all of the various molecular structures likewise being applicable here.

Finally, the invention also relates to a use of a patterned self-assembled monolayer as a mask for the selective plating of metal upon a transparent conductive oxide layer provided upon a photoelectric conversion device, said self-assembled monolayer being arranged to prevent metallic plating where it is present, and being based on molecules terminated by at least one group F which is one of: a phosphonic acid group, a P(O)O₂⁻M⁺ group, an OPO₃H₂ group, or an OP(O)O₂⁻M⁺ group, wherein M⁺ is a metal cation such as Na⁺ or K⁺.

Advantageously, the molecules of the self-assembled monolayer can comprise one or more tail moieties as described above, all of the various molecular structures likewise being applicable here.

### Brief description of the drawings

Further details of the invention will appear more clearly upon reading the description below, in connection with the following figures which illustrate:
- Figure 1: a schematic representation of part of a photovoltaic device according to the invention, this part of a photovoltaic device equally being an intermediate product in the manufacture of said device;
- Figure 2: a schematic representation of a method according to the invention;
- Figure 3: photographs of comparative experimental results of the outcome of a first example of a method according to the invention;
- Figure 4: a confocal microscope image of a nickel track from the experiment of figure 3;
- Figure 5: confocal microscope images of the outcome of a second example of a method according to the invention; and
- Figure 6: a photograph of experimental results of the outcome of a third example of a method according to the invention.

### Embodiments of the invention

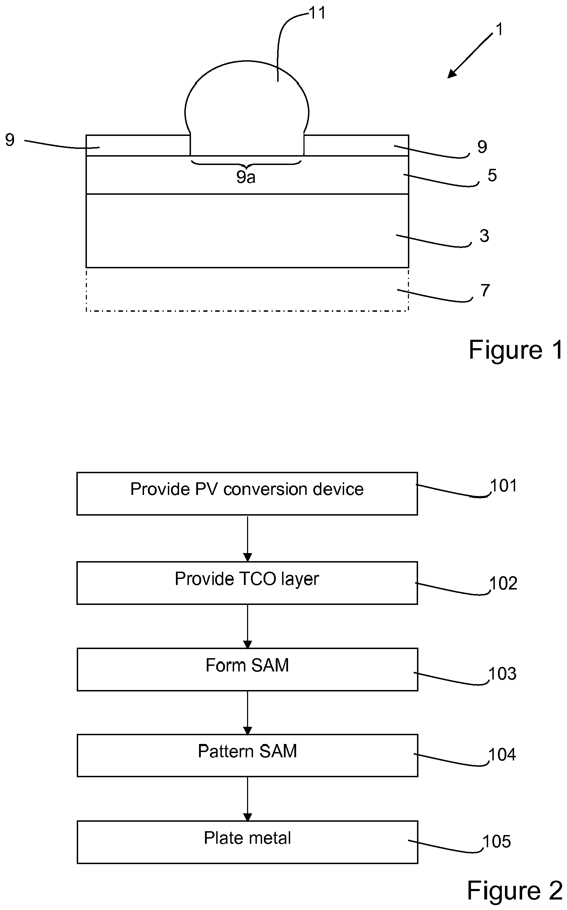

Figure 1 illustrates schematically a part of a photovoltaic (PV) cell 1 made by the method of the invention as outlined in figure 2. This part of a photovoltaic cell 1 constitutes an intermediate product in the manufacture of the final device. It should be noted that only the essential elements have been illustrated, and that further non-illustrated intermediate and outer layers such as passivation layers, substrates, encapsulation layers and so on can also be provided.

The PV cell 1 comprises a photovoltaic conversion device 3, formed in a first step 101. This PV conversion device 3 comprises at least one photovoltaically active junction (PN, NP, PIN, NIP) based on at least one of thin-film silicon (which may be amorphous, microcrystalline, or micromorph in the case of a tandem cell), crystalline (i.e. monocrystalline) silicon, germanium, Perovskite, quantum dot cells, copper indium gallium selenide, cadmium telluride, dye sensitised cells, plasmonic cells, or any other convenient type. The PV device may be based on single layers of cells, multijunction cells, hybrid cells, etc. The PV conversion device 3 may be patterned as required, and may be front-side contacted, back-side contacted, or bifacially-contacted.

Upon at least one face of the PV conversion device 3 , which may be the light-incident side or the rear side (or both sides in the case of a silicon heterojunction cell), is situated a layer of transparent conductive oxide (TCO) 5, which usually has a thickness in the range of 50nm to 150 nm, preferably in the range of 80nm to 120nm, and is typically also patterned. The most commonly used TCO's are indium tin oxide (ITO), indium zinc oxide (IZO) and aluminium zinc oxide (AZO), although other types such as doped or undoped zinc oxide or tin oxide are also possible. This TCO layer 5 is formed directly or indirectly upon said surface of the PV conversion device 3 in step 102, typically by means of chemical vapour deposition as is generally known.

On the face of the photovoltaic conversion device 3 opposite to the TCO layer 5 may optionally be situated one or more further layers 7, in function of the cell construction. For instance, this may be one or more of a substrate, one or more encapsulation layers, a further layer of TCO, a further metallic layer, a passivation layer, a transparent or opaque backsheet, a front sheet (e.g. of glass or polymer) or similar, as is generally known.

The core of the invention is in the manner in which a patterned metallic layer 11 is formed upon the TCO layer 5.

As noted in the introduction, such layers are typically formed lithographically by means of a photostructured photoresist layer, so as to form metallic features such as electrical tracks, electrical pads and similar, typically from materials such as copper, nickel, nickel phosphor, or silver. This latter can also be directly screen-printed or inkjet-printed as an alternative to a lithographic process.

According to the present invention, in step 103, a self-assembled monolayer (SAM) 9 is applied to the free surface of the TCO layer 5, for instance by dip coating, spray coating, bar coating, slot-die coating spin coating or similar in a solution of SAM molecules dispersed in a solvent such as ethanol or isopropanol at a suitable concentration of e.g. 1.0 to 20 mmol/L, preferably 2.5 to 10 mmol/L. Coating may take place at room temperature, but also at elevated temperature such as up to 70°C. Although this layer can be selectively applied to the surface, it is typically applied to substantially the whole surface, since this is significantly simpler to carry out while ensuring a uniform thickness, which is typically from 1 nm to 5nm, preferably from 1.5 nm to 3nm, further preferably from 1.5 to 2.0nm.

SAMs in general are molecular assemblies formed spontaneously on surfaces by adsorption and are organised into more or less large ordered domains, as is generally known from the scientific literature. The SAMs used in the present invention are specially chosen to, on the one hand, bind well to the TCO layer 5, and, on the other hand, to prevent plating where the SAM is present. They also are chemically stable during the subsequent plating process, since such processes are sometimes carried out at high or low pH, as low as pH2, or as high as pH 14, more typically as low as pH 4 or as high as pH 10. Of course, processes at milder pH's such as pH between 5 and 9, preferably between 6 and 8 are also possible, and the present invention is not limited to extreme pH deposition processes.

To this end, the SAM is based on molecules terminated by at least one functional group F which is one of: a phosphonic acid group, a P(O)O₂⁻M⁺ group, an OPO₃H₂ group, or an OP(O)O₂⁻M⁺ group, wherein M⁺ is a metal cation such as Na⁺ or K⁺. This functional group forms a head moiety of the molecule, which binds strongly to the TCO.

According to one general form, the molecules may have at least one tail moiety comprising one or more of the following: a straight or branched alkyl chain having more than 2 carbon atoms covalently bonded in a chain, a straight or branched perfluorinated alkyl chain comprising preferably from 1 to 100 atoms of carbon, one or more aromatic rings, (CF(CF₃)CF₂O)_{q}(CF₂)ₜCF₃, (CF₂CF(CF₃)O)_{q}(CF₂)ₜCF₃, (CF₂CF₂CF₂O)_{q}(CF₂)ₜCF₃, (CF₂CF₂O)_{q}(CF₂)ₜCF₃ in each case with q between 0 and 100, and t between 2 and 100.

According to a second general form, the molecules may have the general formula

F-R1-R'-R2

In which F is the head moiety as defined above, and R1-R'-R2 is the tail moiety in which:
R1 is one of: an alkyl chain, an alkyl chain in which at least one hydrogen atom is substituted with a halogen, an aryl chain, an alkylaryl chain, an aralkyl chain, an aralkyl chain in which at least one hydrogen atom is substituted with a halogen, a branched alkyl chain, a branched aryl chain, a branched aralkyl chain, a branched alkylaryl chain, an oligothioether chain of formula (CH₂CH₂X)ₙ with X being an O or S atom and n being between 1 and 25. In general, where chains are mentioned, these are typically between 1 and 50 carbons long, preferably between 2 and 50 carbons long, further preferably between 8 to 20 carbons long, and hence also include the smallest group of each category of molecule which comprises only one carbon atom.

Specific examples of substances falling within this general formula are the following:
- 12,12,13,13,14,14,15,15,15,15-Nonafluoropentadecylphosphonic acid 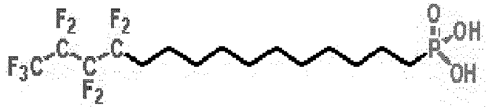
- 12,12,13,13,14,14,15,15,16,16,17,17-Tridecafluoroseptadecylphosphonic acid 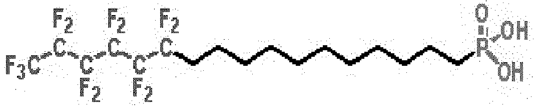
- 12,12,13,13,14,14,15,15,16,16,17,17,18,18,19,19,19-Heptadecafluorononadecylphosphonic acid 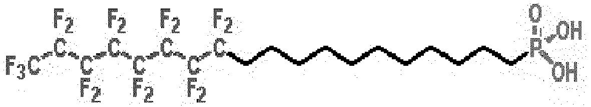
- 10-((3,3,4,4,5,5,6,6,7,7,8,8,9,9,10,10,10-Heptadecafluorodecyloxy)carbonyl)decylphosphonic acid 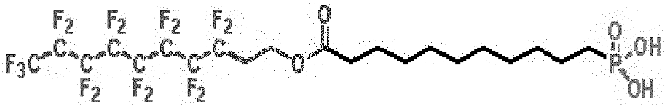
- 5,7,7-Trimethyl-2-(4,4-dimethylpentan-2-yl)octylphosphonic acid 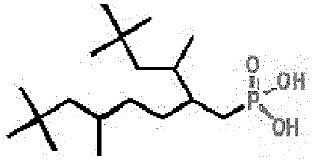
- Diethyl-12-pentafluorophenoxydodecylphosphonate 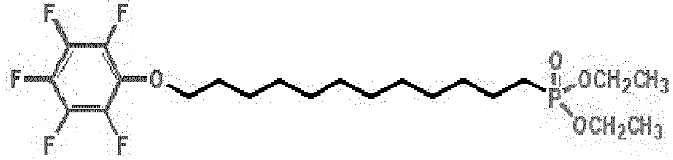
- octadecylphosphonic acid, 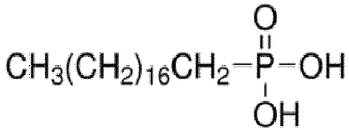
- decylphosphonic acid, 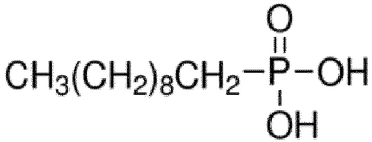
- dodecylphosphonic acid, 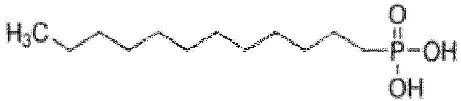
- octylphosphonic acid

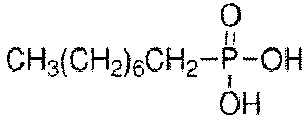

According to a third general form, said molecules are of the general formula

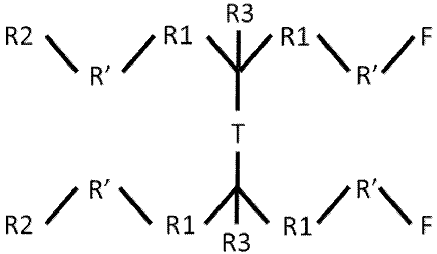

In this formula, F is again a head moiety (of which there are two), and the tail moieties are as illustrated, in which:
R1 is one of: an alkyl chain, an alkyl chain in which at least one hydrogen is substituted by a halogen, an aryl chain, an alkylaryl, an aralkyl chain, an aralkyl chain in which at least one hydrogen is substituted by a halogen, a branched alkyl chain, a branched aryl chain, a branched aralkyl chain, a branched alkylaryl, an oligothioether of formula (CH₂CH₂X)ₙ with X being an O or S atom and n being between 1 and 25,
R' is one of: a bond, (CH₂)ₘ with m between 0 and 100, O, S, S-S, NH, O(CO), O(CS), NH(CO), NH(CS), NH(CO)NH, NH-CS-NH, NH(CO)O, NH(CS)O, S(CO), (CO)S, a triazolium bond,
R2 is one of: alkyl chain, an alkyl chain in which at least one hydrogen is susbtituted by a halogen, an aryl chain, an alkylaryl, an aralkyl chain, an aralkyl chain in which at least one hydrogen is substituted by a halogen, a branched alkyl chain, a branched aryl chain, a branched aralkyl chain, a branched alkylaryl, an oligothioether of formula (CH₂CH₂X)ₚ with X being an O or S atom and p being between 1 and 25, a perfluoroalkyl chain comprising from 1 to 20 carbon atoms, (CF(CF₃)CF₂O)_{q}(CF₂)₂CF₃, (CF₂CF(CF₃)O)_{q}(CF₂)₂CF₃, (CF₂CF₂CF₂O)_{q}(CF₂)₂CF₃, (CF₂CF₂O)_{q}(CF₂)CF₃ with q between 0 and 100.
T is one of: a bond, (CH₂)ᵣ with r between 0 and 100, O, S, S-S, NH, O(CO), O(CS), NH(CO), NH(CS), NH(CO)NH, NH-CS-NH, NH(CO)O, NH(CS)O, S(CO), (CO)S, a triazolium bond,
R3 is one of: H, an alkyl group, an alkyl group in which at least one hydrogen is substituted by a halogen, an aryl group, a branched alkyl, a branched aryl chain, an aralkyle group, an oligothioether of formula (CH₂CH₂X)ₛ with X being an O or S atom and s being between 1 and 25.

A specific example of a particularly advantageous molecule fulfilling this general form is:
- 10,11-Bis(2,2,3,3,4,4,5,5,6,6,7,7,8,8,9,9,9-Heptadecafluorononyl)icosane-1,20-diyldiphosphonic acid

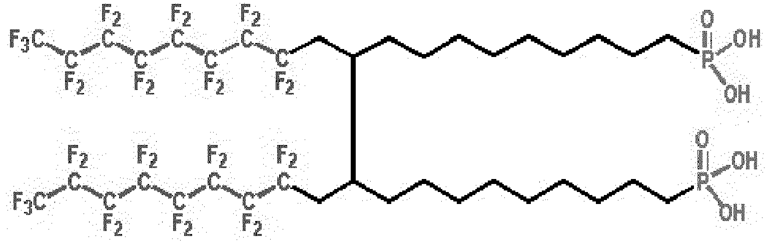

After application of the SAM 9, the workpiece can be rinsed if required, e.g. with ethanol, and can then be dried and cured, e.g. in a vacuum oven at e.g. 120°C for 30 minutes. Other temperatures and times are of course also possible in function of the SAM and solvent used.

SAM 9 is then subsequently patterned in step 104 to leave plateable zones 9a in which the SAM 9 is removed in order to reveal the underlying TCO layer 5. This patterning can be carried out by various methods such as laser ablation, dry etching through a hard silicon mask by means of oxygen plasma, acid etching, UV-Ozone, corona treatment, mechanical removal, or similar, the patterned SAM layer forming a plating mask. The tail moieties mentioned above are all highly hydrophobic, and the SAM molecules are electrically insulating, and hence plating does not take place where the SAM molecules cover the surface of the TCO layer 5.

Subsequently, in step 105, the metallic features 11 are plated onto the plateable zones 9a. The metal chosen is typically copper, but nickel, silver, tin, cobalt, titanium, tantalum, tungsten, molybdenum, nickel-phosphor, and alloys of the foregoing and silver are also possibilities.

This plating can be carried out using a conventional electroplating bath, a conventional electroless plating (i.e. autocatalytic plating) bath, deposition from aqueous solution of ionic liquids, or similar, by immersing the workpiece therein as is generally known. A seed layer of e.g. a solution or suspension of an appropriate plating catalyst (e.g. a solution or suspension of metal ions, colloid silver, a metal complex or similar) may be applied on the plateable zones 9a prior to plating, as is generally known.

Subsequently, the PV device 1 can be rinsed and dried.

Since the SAM layer 9 is very thin and is transparent, it is not always necessary to remove it after plating, removing a significant process step in cases in which this is possible. Indeed, if the formation of the metallic features 11 was the last processing step on the PV device 1 itself, encapsulation and assembly into a module can follow immediately. However, the SAM layer 9 can indeed be removed with an appropriate solvent if required.

A number of experimental results applying the method are reported below.

### Example 1

A piece of silicon wafer with dimensions 5x5 cm² was provided, so as to simulate PV conversion device 3. This was coated with a TCO layer of indium tin oxide with a thickness of 100nm.

This workpiece was then rinsed with isopropanol in an ultrasonic bath to remove possible organic contamination, then rinsed in ethanol in an ultrasonic bath and dried. The substrate is then treated with a diffusive oxygen plasma for 15 min at room temperature in order to ensure that the TCO surface is chemically clean.

The workpiece then immersed in a 5 mmol/L solution of 12,12,13,13,14,14,15,15,15,15-nonafluoropentadecylphosphonic acid in ethanol for 30 minutes at a temperature 70°C. The workpiece was then rinsed in ethanol, and dried. It was then placed for extra curing at 150°C for 2 hours in a vacuum oven.

The thus prepared SAM layer 9 of 12,12,13,13,14,14,15,15,15,15-nonafluoropentadecylphosphonic acid was then patterned by covering the sample with a silicon hard mask containing lines of varying width and placed under a reactive ion etching (RIE) oxygen plasma for selective SAM removal. By so doing, plateable zones 9a were created, in which the underlying TCO layer 5 was exposed.

To create a contact for the electroplating step, the SAM 9 was removed on one edge by dipping in concentrated sulfuric acid (96%) for between 1 and 3 minutes, so as to enable electrical contact with the TCO layer 5. The workpiece and a non-patterned reference workpiece were then placed in an electroplating bath at pH 4 and temperature of 50°C. The electrolyte is chloride free Ni-sulphamate. A constant voltage of 2V was applied during 5 minutes at an electrode contacted with the workpiece or the back side of the workpiece.

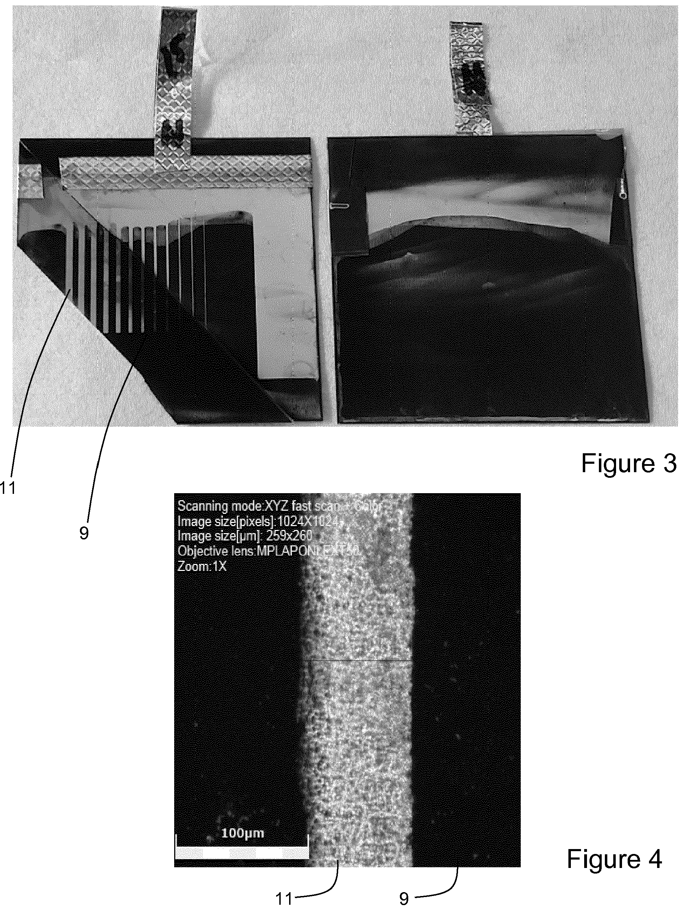

The results of this experiment are shown in figure 3. On the left sample, nickel plated lines of various thicknesses (the zones of light coloration) corresponding to the patterning can be seen, whereas there was no nickel deposition on the non-patterned reference sample (the zones of dark coloration) away from the electrical contact zone formed by dipping in sulphuric acid. Furthermore, figure 4 illustrates confocal microscope image of one of the nickel lines formed on the patterned sample.

### Example 2

Again, a silicon wafer of dimensions 5x5 cm² provided with a TCO layer was used as a workpiece for this experiment, the SAM layer 9 being provided as before.

In order to pattern the SAM layer 9 so as to define plateable zones 9a in which the surface of the TCO layer 5 is exposed, a Trumpf marking laser was used to laser ablate the SAM along a line.

The workpiece was then plated as before.

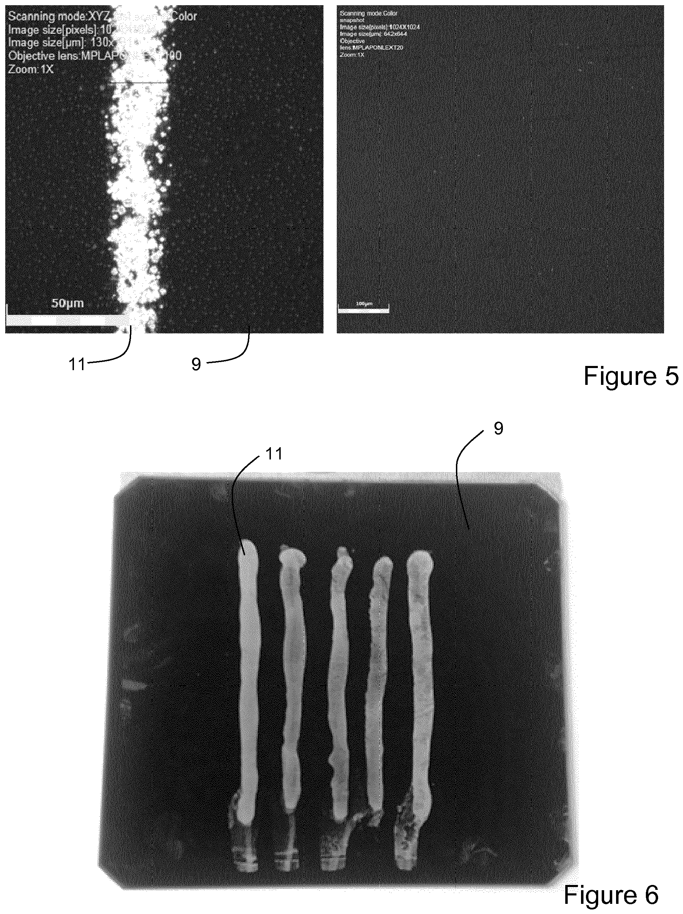

Figure 5 illustrates the results of this experiment, the left-hand image being a confocal microscope image of the nickel-plated track, and the right-hand image being a confocal microscope image of an unablated region of the workpiece.

### Example 3

In this example, the substrate is as before, but has dimensions of 15x15 cm2, with a TCO layer 5 on both sides, one of the TCO layers being silver coated with 200nm thick sputtered silver on the side opposite to the exposed TCO layer 5.

This workpiece was prepared for SAM coating as before, and was then coated by being manually sprayed with a 5 mmol/L solution of 12,12,13,13,14,14,15,15,15,15-nonafluoropentadecylphosphonic acid. The excess was removed by rinsing in ethanol, and the workpiece was dried. The substrate was then cured at 150°C for 30 minutes in a vacuum oven. The substrate was then manually sprayed again, rinsed again and placed again at 150°C in a vacuum oven for 30 minutes.

The SAM layer 9 was then patterned by forming lines of approximatively 0.5 cm using H₂SO₄ at 96% concentration wt/wt on the surface of the SAM layer 9 for 1 to 2 minutes, and then rinsing.

The plating was performed using a chloride free nickel sulphamate bath at pH 5.8 and T 42°C. The applied voltage is 2.6V for 2 minutes, the silver backing to the silicon wafer being used as an electrical contact. As can be seen on figure 6, the surface outside the conductive lines 11 remains hydrophobic after plating, evidencing the resistance of the SAM to the plating conditions. Some nickel marks are observed where the sample was handled.

As can be seen from the foregoing it is clear that the method of the invention can be carried out with simple equipment, using a minimum of materials. In particular, the SAM is cheaper, faster and easier to use than a conventional photoresist-based lithography, or printing of masking material. Furthermore, removal of the SAM layer is not necessarily required, reducing the requirements for solvents and the time required to strip the masking material. The lower overall quantities of chemicals used, particularly in respect of the comparatively small amounts of SAM molecules, and the simple, standard solvents used, are highly cost-effective and environmentally friendly.

Although the invention has been described with reference to specific embodiments, variations are possible without departing from the scope of the invention as defined in the appended claims.

## Claims

1. Method of manufacturing a photovoltaic cell (1), comprising the steps of:
- providing a photovoltaic conversion device (3);
- providing a transparent conductive oxide layer (5) upon at least a first face of said photovoltaic conversion device (3);
- forming a self-assembled monolayer (9) on said transparent conductive oxide layer (5), said self-assembled monolayer (9) being based on molecules terminated by at least one functional group F which is chosen from: a phosphonic acid group, a P(O)O₂⁻M⁺ group, a OPO₃H₂ group, or an OP(O)O₂⁻M⁺ group, wherein M⁺ is a metal cation;
- patterning said self-assembled monolayer (9) so as to define at least one plateable zone (9a) in which said transparent conductive oxide layer (5) is exposed;
- plating a metal (11) onto said at least one plateable zone (9a).

2. Method according to claim 1, wherein said molecules have at least one tail moiety comprising at least one of:
- a straight alkyl chain comprising at least two carbon atoms;
- a straight alkyl chain comprising at least two carbon atoms in which at least one hydrogen is substituted by a halogen;
- a branched alkyl chain comprising at least two carbon atoms;
- a straight perfluorinated alkyl chain comprising preferably from 1 to 100 atoms of carbon;
- a branched perfluorinated alkyl chain comprising preferably from 1 to 100 atoms of carbon;
- one or more aromatic rings;
- (CF(CF₃)CF₂O)_{q}(CF₂)ₜCF₃ with q between 0 and 100, and t between 2 and 100;
- (CF₂CF(CF₃)O)_{q}(CF₂)ₜCF₃ with q between 0 and 100, and t between 2 and 100;
- (CF₂CF₂CF₂O)_{q}(CF₂)ₜCF₃ with q between 0 and 100, and t between 2 and 100;
- (CF₂CF₂O)_{q}(CF₂)ₜCF₃ with q between 0 and 100, and t between 2 and 100.

3. Method according to claim 1, wherein said molecules are of the general formula:
F-R1-R'-R2
wherein :
- R1 is one of: an alkyl chain, an alkyl chain in which at least one hydrogen atom is substituted with a halogen, an aryl chain, an alkylaryl chain, an aralkyl chain, an aralkyl chain in which at least one hydrogen atom is substituted with a halogen, a branched alkyl chain, a branched aryl chain, a branched aralkyl chain, a branched alkylaryl chain, an oligothioether chain of formula (CH₂CH₂X)ₙ with X being an O or S atom and n being between 1 and 25,
- R' is one of : (CH₂)ₘ with m between 0 and 100, O, S, S-S, NH, O(CO), O(CS), NH(CO), NH(CS), NH(CO)NH, NH-CS-NH, NH(CO)O, NH(CS)O, S(CO), (CO)S, triazolium,
- R2 is one of: an alkyl chain, an alkyl chain wherein at least one atom of hydrogen is substituted by a halogen, an aryl chain, an alkylaryl, an aralkyl chain, an aralkyl chain wherein at least one atom of hydrogen is substituted by a halogen, a branched alkyl chain, a branched aryl chain, a branched aralkyl chain, a branched alkylaryl, an oligothioether of formula (CH₂CH₂X)ₚ with X being an O or S atom and p being between 1 and 25, a perfluoroalkyl chain comprising from 1 to 20 carbon atoms, (CF(CF₃)CF₂O)_{q}(CF₂)₂CF₃ with q between 0 and 100, (CF₂CF(CF₃)O)_{q}(CF₂)2CF₃ with q between 0 and 100, (CF₂CF₂CF₂O)_{q}(CF₂)₂CF₃ with q between 0 and 100, (CF₂CF₂O)_{q}(CF₂)CF₃ with q between 0 and 100.

4. Method according to the preceding claim, wherein said molecule is one of:
• 12,12,13,13,14,14,15,15,15,15-Nonafluoropentadecylphosphonic acid,
• 12,12,13,13,14,14,15,15,16,16,17,17-Tridecafluoroseptadecylphosphonic acid,
• 12,12,13,13,14,14,15,15,16,16,17,17,18,18,19,19,19-Heptadecafluorononadecylphosphonic acid,
• 10-((3,3,4,4,5,5,6,6,7,7,8,8,9,9,10,10,10-Heptadecafluorodecyloxy)carbonyl)decylphosphonic acid,
• 5,7,7-Trimethyl-2-(4,4-dimethylpentan-2-yl)octylphosphonic acid
• Diethyl-12-pentafluorophenoxydodecylphosphonate,
• octadecylphosphonic acid,
• decylphosphonic acid,
• dodecylphosphonic acid,
• octylphosphonic acid.

5. Method according to claim 1, wherein said molecules are of the general formula 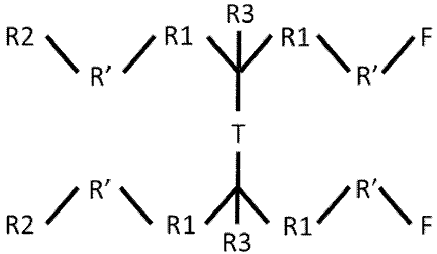 wherein:
- R1 is one of: an alkyl chain, an alkyl chain in which at least one hydrogen is substituted by a halogen, an aryl chain, an alkylaryl, an aralkyl chain, an aralkyl chain in which at least one hydrogen is substituted by a halogen, a branched alkyl chain, a branched aryl chain, a branched aralkyl chain, a branched alkylaryl, an oligothioether of formula (CH₂CH₂X)ₙ with X being an O or S atom and n being between 1 and 25,
- R' is one of: a bond, (CH₂)ₘ with m between 0 and 100, O, S, S-S, NH, O(CO), O(CS), NH(CO), NH(CS), NH(CO)NH, NH-CS-NH, NH(CO)O, NH(CS)O, S(CO), (CO)S, a triazolium bond,
- R2 is one of: alkyl chain, an alkyl chain in which at least one hydrogen is susbtituted by a halogen, an aryl chain, an alkylaryl, an aralkyl chain, an aralkyl chain in which at least one hydrogen is substituted by a halogen, a branched alkyl chain, a branched aryl chain, a branched aralkyl chain, a branched alkylaryl, an oligothioether of formula (CH₂CH₂X)ₚ with X being an O or S atom and p being between 1 and 25, a perfluoroalkyl chain comprising from 1 to 20 carbon atoms, (CF(CF₃)CF₂O)_{q}(CF₂)2CF₃ with q between 0 and 100, (CF₂CF(CF₃)O)_{q}(CF₂)₂CF₃ with q between 0 and 100, (CF₂CF₂CF₂O)_{q}(CF₂)₂CF₃ with q between 0 and 100, (CF₂CF₂O)_{q}(CF₂)CF₃ with q between 0 and 100.
- T is one of: a bond, (CH₂)ᵣ with r between 0 and 100, O, S, S-S, NH, O(CO), O(CS), NH(CO), NH(CS), NH(CO)NH, NH-CS-NH, NH(CO)O, NH(CS)O, S(CO), (CO)S, a triazolium bond,
- R3 is one of: H, an alkyl group, an alkyl group in which at least one hydrogen is substituted by a halogen, an aryl group, a branched alkyl, a branched aryl chain, an aralkyle group, an oligothioether of formula (CH₂CH₂X)ₛ with X being an O or S atom and s being between 1 and 25.

6. Method according to the preceding claim, wherein said molecules are 10,11-Bis(2,2,3,3,4,4,5,5,6,6,7,7,8,8,9,9,9-Heptadecafluorononyl)icosane-1,20-diyldiphosphonic acid.

7. Method according to any preceding claim, wherein, after said step of plating, said self-assembled monolayer (9) is left in place.

8. Method according to any preceding claim, wherein said self-assembled monolayer (9) has a thickness or 2 nm to 5 nm, preferably from 3 nm to 4 nm.

9. Method according to any preceding claim, wherein said self-assembled monolayer (9) is cured in a vacuum oven prior to patterning.

10. Method according to any preceding claim, wherein said self-assembled monolayer (9) is formed by:
- a first application of said molecules;
- a first drying and curing;
- a second application of said molecules; and
- a subsequent drying and curing.

11. Method according to any preceding claim, wherein said patterning is carried out by at least one of:
- selective laser ablation;
- reactive ion etching through a mask;
- selective application of an acid.

12. Intermediate product (1) comprising:
- a photoelectric conversion device (3);
- a transparent conductive oxide layer (5) provided upon said photoelectric conversion device (3);
- a patterned self-assembled monolayer (9) provided upon said transparent conductive oxide layer and defining at least one plateable zone (9a) free of said self-assembled monolayer, said self-assembled monolayer being based on molecules terminated by at least one group F which is one of: a phosphonic acid group, a P(O)O₂⁻M⁺ group, an OPO₃H₂ group, or an OP(O)O₂⁻M⁺ group, wherein M⁺ is a metal cation; and
- a metallic layer (11) provided on said at least one plateable zone (9a).

13. Photoelectric module comprising at least one intermediate product (1) according to claim 12 encapsulated therein.

14. Use of a patterned self-assembled monolayer (9) as a mask for the selective plating of metal upon a transparent conductive oxide layer (5) provided upon a photoelectric conversion device (3), said self-assembled monolayer (9) being arranged to prevent metallic plating and being based on molecules terminated by at least one group F which is one of: a phosphonic acid group, a P(O)O₂⁻M⁺ group, an OPO₃H₂ group, or an OP(O)O₂⁻M⁺ group.
